(19) Europäisches Patentamt

European Patent Office

Office européen des brevets

(11)  **EP 0 642 135 B1**

(12)  **EUROPEAN PATENT SPECIFICATION**

(45) Date of publication and mention
of the grant of the patent:
**03.05.2000  Bulletin 2000/18**

(51) Int. Cl.$^7$: **G11C 29/00**,  G11C 16/06

(21) Application number: **94112764.9**

(22) Date of filing: **16.08.1994**

(54) **A nonvolatile semiconductor memory and its test method**

Nichtflüchtiger Halbleiterspeicher und Prüfverfahren

Mémoire non-volatile à semi-conducteur et procédé de test

(84) Designated Contracting States:
**DE FR GB IT**

(30) Priority: **08.09.1993 JP 22371893**

(43) Date of publication of application:
**08.03.1995  Bulletin 1995/10**

(73) Proprietor: **FUJITSU LIMITED**
**Kawasaki-shi, Kanagawa 211 (JP)**

(72) Inventor:
**Watanabe,Hisayoshi,**
**c/o Fujitsu Ltd.,**
**Patent Dept.**
**Kawasaki-shi, Kanagawa 211 (JP)**

(74) Representative:
**Stebbing, Timothy Charles et al**
**Haseltine Lake & Co.,**
**Imperial House,**
**15-19 Kingsway**
**London WC2B 6UD (GB)**

(56) References cited:
**EP-A- 0 403 822          EP-A- 0 537 082**

• **PATENT ABSTRACTS OF JAPAN vol. 017, no. 585 (P-1632), 25 October 1993 & JP 05 166390 A (RICOH CO LTD), 2 July 1993**

Printed by Xerox (UK) Business Services
2.16.7 (HRS)/3.6

## Description

BACKGROUND OF THE INVENTION

1. Field of the Invention

The present invention relates to a nonvolatile semiconductor memory and its test method, and more specifically relates to improvements of an automatically and electrically chip-erasable memory in which a pre-erase write is executed in an automated erase operation.

2. Description of the Related Art

Recently, as various sorts of information processing systems increase in their performance and the number of their functions, nonvolatile memories has come to be used which store the control algorithm for each system as programmed data in memory cells.

For example, in an electrically rewritable and electrically chip-erasable memory (a flash $E^2P$-ROM), there are needs for an assurance of the number of rewrites, a shorter test period and better test efficiency.

According to such conventional flash memory, in performing an automated rewrite and erase test which serves as a test of functions and operations of a flash memory, a data write operation is performed on the basis of a program command from an external device prior to an automated erase and then an erase operation is performed by an erase command from the external device (Hereinafter, such data write operation or pre-erase conditioning is referred to as "pre-programming").

Thus, a rewrite test requires repetition of an automated write which is executed prior to an automated erase (hereinafter, referred to as an "auto-erase") based on a program command (a pre-programming) and an automated erase based on an erase command causing the test period to be long and causing the data write based on the program command to prevent a precise erase characteristic from being obtained.

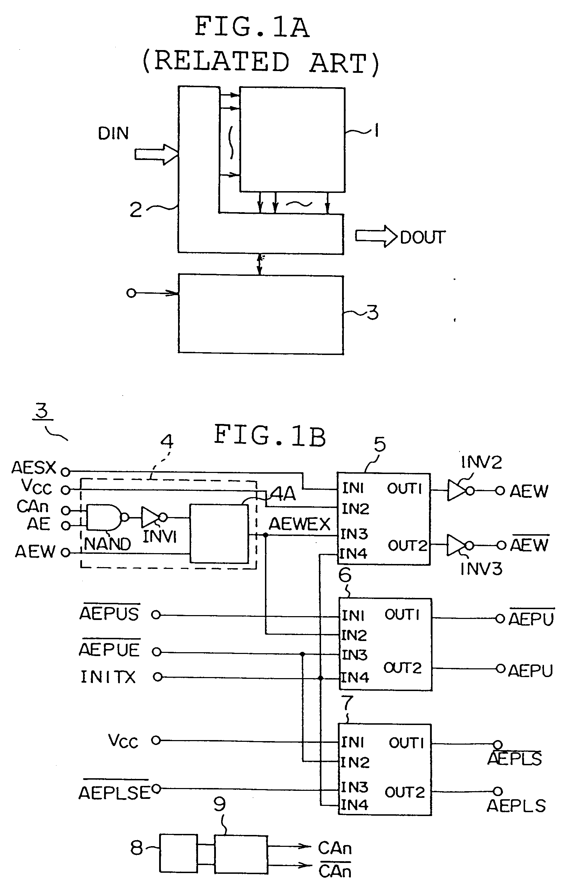

Now, the related art of the invention will be described in the following. For example, as shown in FIG. 1A, an automatically and electrically chip-erasable memory into which erase data are written before an auto-erase comprises a storage section 1, a write/read section 2 and an erase/write controller 3.

The erase/write controller 3 as shown in FIG. 1B comprises a write-completion detector 4, latch circuits 5 through 7, an oscillator 8, inverters INV1 and INV2 and a counter 9 to control inputs and outputs of the storage section 1 and the write/read section 2 on the basis of a test algorithm or a series of write and erase commands.

Here, an erase command means the operational instructions of writing erase data into the relevant cells and erasing the contents of all the cells, that is, injecting hot electrons into the cells and then repeating an extraction of hot electrons through the F-N (Flower-Nordheim) tunnel a few through thousands of times.

Also, a pre-erase write (command) is an operation of making the threshold voltages of all the cells even in a high level for reducing the variety of the threshold voltages of the cells in the storage section 1.

The write-completion detector 4 comprises a 2-input negated logical product circuit NAND, an inverter INV1 and a trigger circuit 4A, and outputs a pre-programming termination signal AEWEX to latches 5 and 6 on the basis of a last count value signal Can, an auto-erase signal AE and a pre-programming signal AEW.

As for the function of the present circuit, in an erase and write test of the flash memory, the oscillator 8 first generates a non-inverted reference clock signal CLK and an inverted reference clock signal $\overline{CLK}$, on the basis of which addresses are generated by the counter circuit 9.

Also, as shown in FIG. 1B, the latch circuit 5 is supplied with an auto-erase start signal AESX and an initial signal INITX, and the write-completion detector 4 is supplied with the signal Can (CA18), the signal AE and the signal AEW. Note that the signal Can is one indicating the last count value of the counter circuit 9.

Thus, the signal AEWEX is supplied from the write-completion detector 4 to the latch circuit 5 and 6. A non-inverted signal AEW and an inverted signal $\overline{AEW}$ are supplied from the latch circuit 5 via inverters INV2 and INV3, respectively.

On the other hand, a latch circuit 6 latches and outputs an erase voltage control signal AEPU and an inverted erase voltage control signal $\overline{AEPU}$ on the basis of an erase voltage control signal AEPUE, the signals INITX and AEWEX.

A latch circuit 7 latches and outputs a non-inverted auto-erase pulse signal AEPLS and an inverted auto-erase pulse signal $\overline{AEPLS}$ on the basis of an auto-erase pulse termination signal $\overline{AEPLSE}$ and the signal INITX.

Thus, an erase/write voltage generator in the write/read section 2 connected to the erase/write controller 3 is controlled in timing on the basis of signals AEW, $\overline{AEW}$, AEPU, $\overline{AEPU}$, AEPLS and $\overline{AEPLS}$, data for erasing are written into the storage section 1 before an auto-erase, and then a data erase operation is repeated.

EP-A-0 537 082 discloses a nonvolatile semiconductor memory according to the preamble of accompanying claim 1. In this semiconductor memory, the number of write operations is fixed relative to the number of erase operations.

According to a first aspect of the present invention, there is provided an electrically chip-erasable nonvolatile semiconductor memory comprising memory cells, which can be written to before a data erase of said memory cells so as to level the threshold voltage of a gate of a transistor constituting each cell; characterised by: output means for outputting a count selection signal and one of a plurality of preset data write counts, which define the number of write operations before data erase of said memory cells, whereby said preset data write counts differ from one another and include one write count being zero; and control means for writing data to said memory cells according to said data write count from said output means and executing data write and erase in response to an erase signal.

According to a second aspect of the present invention, there is provided a test method of an electrically chip-erasable nonvolatile semiconductor memory comprising memory cells, which can be written to before a data erase of said memory cell so as to level the threshold voltage of a gate of a transistor constituting each cell, said method comprising the steps of: presetting a plurality of data write counts which define the number of write operations before data erase of said memory cells, whereby said preset data write counts differ from one another and include one write count being zero; selecting one of said preset write counts in an automated erase and rewrite test; and executing data writes according to said selected data write count and executing data write and erase in response to an erase signal.

An embodiment of the invention may reduce the time taken for a test of data rewrite or data erase by devising the arranging method of a rewrite test and an erase test, seize the erase characteristic precisely by omitting the write test prior to an auto-erase and make a rewrite test with only an auto-erase by making the number of write operations before an auto-erase changeable.

According to an automatically and electrically erasable nonvolatile semiconductor memory of the invention, the program command for programming before an auto-erase is disabled, and an erase data write and an auto-erase are executed according to an erase instruction.

Specifically, in the inventive nonvolatile semiconductor memory, a control means is provided with an automated count setter, which is connected to the test mode terminals which serve both as regular input terminals and test terminals.

When a test voltage higher than the usually used voltage is applied to any of the test mode terminals, the state of the applied voltage to the test mode terminal is detected by the automated count setter. A preset count of data writes before auto-erase is altered by the automated count setter automatically selecting one of the predetermined write counts on the basis of the detected applied voltage state.

Also, if applying the test voltage higher than the usually used voltage is applied to any of the test mode terminals, an auto-erase test can be made by omitting a data write operation before auto-erase and only repeating an erase operation according to the automated count setter.

A test method of a nonvolatile semiconductor memory according to the invention comprises the steps of disabling a program command for writing data before an auto-erase, writing erase data by an erase command and then executing the auto-erase.

According to the inventive test method of a nonvolatile semiconductor memory, write counts including zero are allocated to two or more test mode terminals, to one of which a test voltage higher than the usually used voltage in an automated erase and write test.

Thus, by means of a selection of the test mode terminals, data writes preceding an auto-erase can be omitted and the count of writes preceding an auto-erase can be changed. And, thereby, an automated rewrite only based on an erase command and a speedy and precise cycling test of erase and write become possible.

Therefore, the present invention enables us to obtain a more precise erase characteristic as compared with the related art and provides high efficiency of tests and evaluation. It also contributes to the supply of nonvolatile semiconductor memories such as flash memories with high reliability.

BRIEF DESCRIPTION OF THE DRAWINGS

FIG. 1A is a diagram showing an arrangement of a flash memory including an erase/write controller according to the related art of the invention;
FIG. 1B is a diagram showing the internal structure of the erase/write controller shown in FIG. 1A;

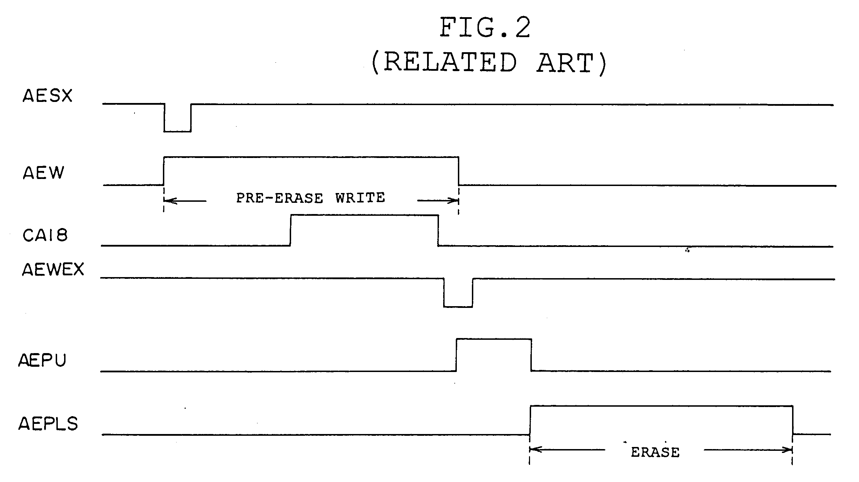

FIG. 2 is a diagram showing wave-forms in operation of the erase/write controller shown in FIG. 1A;
FIG. 3 is a diagram showing a principle arrangement of a nonvolatile semiconductor memory and its test method according to the present invention;
FIG. 4 is a diagram showing a principle arrangement of the automated count setter of a nonvolatile semiconductor memory shown in FIG. 3;
FIG. 5 is a diagram showing a overall arrangement of a flash memory according to a preferred embodiment of the invention;
FIG. 6 is a diagram showing an arrangement of the erase/write controller of the flash memory shown in FIG. 5;
FIG. 7 is a diagram showing an internal structure of the voltage detector in the erase/write controller shown in FIG. 6;
FIG. 8 is a diagram showing a structure of each trigger circuit in the erase/write controller shown in FIG. 6;
FIG. 9 is a diagram showing an overall structure of the counter in the erase/write controller shown in FIG. 6;

FIG. 10 is a diagram showing a structure of each counter circuit in the erase/write controller shown in FIG. 6; and

FIG. 11 is a diagram showing a structure of each latch circuit in the erase/write controller shown in FIG. 6.

DETAILED DESCRIPTION

According to the related art of the invention, in an auto-program and erase test, a data write operation is first executed and subsequently an auto-erase operation is executed, on the basis of the state of applied voltages of specific terminals, a write and an erase command from a tester apparatus.

In this case, since the count of writes before the auto-erase is fixed, a write operation before an erase can not be omitted nor can the write count be altered. This causes the problems that it takes long time for the test and that a precise erase characteristic can not be obtained.

Specifically, in a cycling test wherein a write and an erase (or a rewrite) of data are repeated, since a series of a write and an erase command must be executed alternately on the basis of a test algorithm, it takes significant time to decode all such commands. Since the auto-erase operation must be executed with an erase command after a fixed count of auto-programs have been invariably executed, the test takes time.

Thus, in an auto-erase of the related art, the pre-programming prevents an erase characteristic from being precisely obtained. This is because the decoding of program instructions which are invariably transferred before an auto-erase in a test algorithm takes additional time, which is added to the erase time showing the erase performance of the flash memory.

It is noted that a method of testing a memory by detecting the state of applied voltages to its specific terminals utilizes a power supply voltage detector circuit for which the applicant of the present invention has previously gotten a patent (Japan Patent Publication No. 60,789 in 1989).

On the other hand, in a principle nonvolatile semiconductor memory of the invention, comprises disabling means for disabling a write instruction causing the memory cells to be filled up with data before chip-erase so as to level the threshold voltage of the gate of a transistor constituting each cell; and execution means for executing data write and data erase according to an erase instruction is supplied after the write instruction.

Further an electrically chip-erasable nonvolatile semiconductor memory comprises output means for outputting the count of data writes according to state of data in memory cells before chip-erase and a count selection signal; and control means for writing data to memory cells according to the data write count from the output means and executing data write and erase according to an erase instruction.

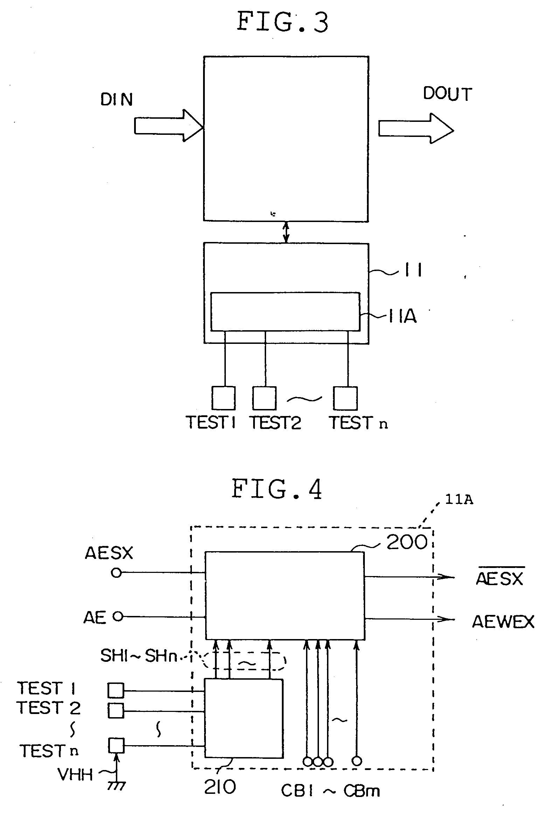

More specifically, in an inventive nonvolatile semiconductor memory in which data DIN stored in its memory cells can be automatically and electrically erasable as shown in FIG. 3, control means 11 for controlling an erase and program operation is provided with a automated count setter 11A, which is connected to the test mode terminals $TEST_i$ [i=1,2,3,...n] which serve both as regular input terminals and test terminals. In an auto-erase and program test, the automated count setter 11A outputs one of the preset write counts, $N_i$, in response to the detection of the state of applied voltages to the test mode terminals, where $N_i$ is a positive integer including zero.

As shown in FIG. 4, the automated count setter 11A in the nonvolatile semiconductor memory of the invention includes a voltage detector 210 for detecting the state of the voltage applied to a specific test mode terminal $TEST_i$ to output the count selection signal $SH_i$ and a timing signal generator 200 for generating a pre-programming termination signal AEWEX and the inverted version $\overline{AESX}$ of an auto-erase initiation signal AESX on the basis of the count selection signal $SH_i$ supplied from the voltage detector 210, an auto-erase initiation signal AESX, a pre-programming control signal AE and count setting signals CB1 through CBm, the last three kinds of signals being supplied from some other component than the voltage detector 210.

A test method of an electrically chip-erasable nonvolatile semiconductor memory comprising the steps of disabling a write instruction which causes the memory cells to be filled up with data before chip-erase so as to level the threshold voltage of the gate of a transistor constituting each cells; and executing data write and data erase according to an erase instruction supplied after the write instruction.

Further a test method of an electrically chip-erasable nonvolatile semiconductor memory comprising the steps of presetting a plurality of data write counts which each define the number of write operation before chip-erase and which differ from one another; selecting one of the preset data write counts in an automated erase and rewrite test; and executing data writes according to the selected data write count and executing data write and erase according to an erase instruction.

More specifically, according to the test method of the nonvolatile semiconductor memory of the invention; program counts $N_1$ through $N_n$ including zero are allocated for two or more test mode terminals $TEST_1$ through $TEST_n$; a test voltage higher than a usually used one is applied to a specific one of the test mode terminals $TEST_i$ through $TEST_n$; and in response to the selected test mode terminal TESTi, a corresponding write count Ni including zero is output.

Now, we discuss the operation of a principle nonvolatile semiconductor memory of the invention. In FIG. 4, if a test voltage higher than a usually used voltage, VHH, is applied to any one of test node terminals

$TEST_1$ through $TEST_n$, e.g., $TEST_i$, then the voltage detector 210 in the automated count setter 11A detects the voltage higher than the usually used one VCC being applied to the terminal $TEST_i$. In response to the detection, the voltage detector 210 supplies a count selection signal $SH_i$ to the timing signal generator 200.

In the timing generator 200, a pre-programming termination signal AEWEX and the inverted version $\overline{AESX}$ of an auto-erase initiation signal AESX are generated on the basis of the count selection signal $SH_i$ supplied from the voltage detector 210, an auto-erase initiation signal AESX, a pre-programming control signal AE and count setting signals $CB_1$ through $CB_m$, the last three kinds of signals being supplied from some other component than the voltage detector 210.

Thus, the automated count setter 11A can select one out of the predetermined write counts, $N_i$, on the basis of the count selection signal $SH_i$. By doing this, it is possible to omit a test of a program before an auto-erase and to change the number of programs before an auto-erase.

As described above, according to the test method of the nonvolatile semiconductor memory of the invention two or more program counts $N_1$ through Nn including zero are allocated to test mode terminals $TEST_1$ through $TEST_n$ and a test voltage higher than a usually used one is applied to a specific one $TEST_i$ of the test mode terminals. Thus, if an erase command is issued to the memory when all of the test mode terminals $TEST_1$ through $TEST_n$ are in a unselected state, then out of recognition that the mode should not enter any test mode, a data write is executed once before an auto-erase and subsequently a pre-programming termination signal AEWEX and an auto-erase initiation signal AESX are generated for entering the auto-erase operation by the timing signal generator 200.

If a terminal, e.g., $TEST_n$ is selected out of the test mode terminals $TEST_1$ through $TEST_n$, that is, the test voltage VHH is applied to the terminal $TEST_n$, the timing signal generator 200 generates a pre-programming termination signal AEWEX to omit a pre-programming ($N_n=0$) in an auto-erase and program test.

Thus, a pre-programming instruction can be disabled, that is, a data write before an auto-erase can be eliminated and thereafter an auto-erase test in which an erase operation is repeated is made by means of control means 11. Since a write count including zero can be selected instead of being fixed as is the case in the related art, a time period used for pre-programming operation is reduced and therefore a test period is reduced. Additionally, a precious erase characteristic can be obtained.

If any other test mode terminal $TEST_i$ other than $TEST_n$ is selected, that is, i≠n, then a pre-programming is executed $N_i$ times on the basis of the count selection signal $SH_i$ for selecting the corresponding write count Ni among the predetermined write counts $N_1$ through $N_{n-1}$, and a pre-programming termination signal AEWEX and an auto-erase initiation signal AESX is generated by the timing signal generator 200 to enter an erase operation.

In this way, a pre-programming count is selected according to the characteristic of the memory by means of an erase command and a selection among the test mode terminals $TEST_1$ through $TEST_n$ from the tester apparatus.

Referring to the drawings, we discuss some illustrative embodiments of the invention in the following.

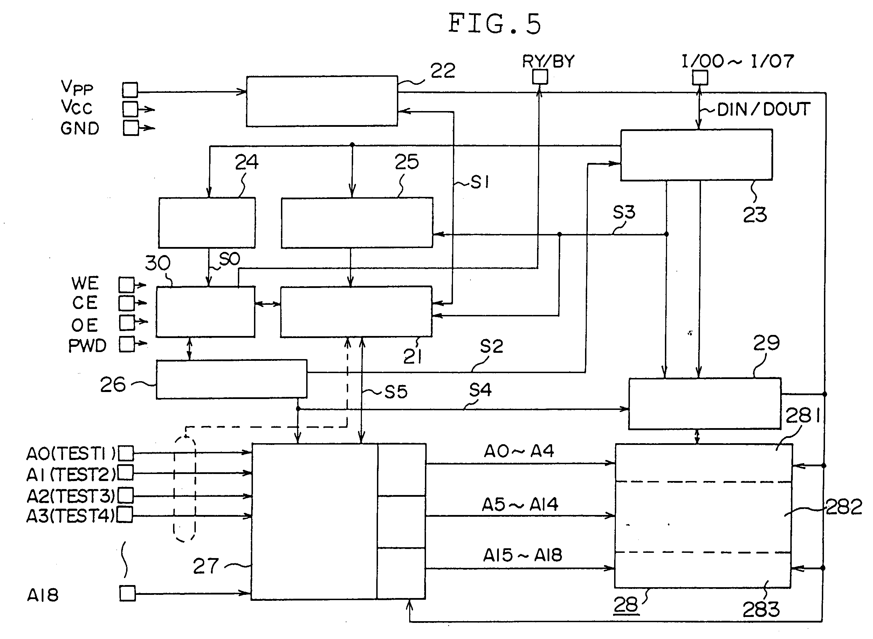

As shown in FIG. 5, for example, an automatically and electrically chip-erasable memory in which the number of programs before an auto-erase is changeable and even made zero comprises an erase/program controller 21, a program/erase voltage generator 22, an input/output buffer 23, a command register 24, a data comparison register 25, a signal generating logic circuit 26, an address latch 27, a storage section 28, a write/read amplifier 29 and a status register 30.

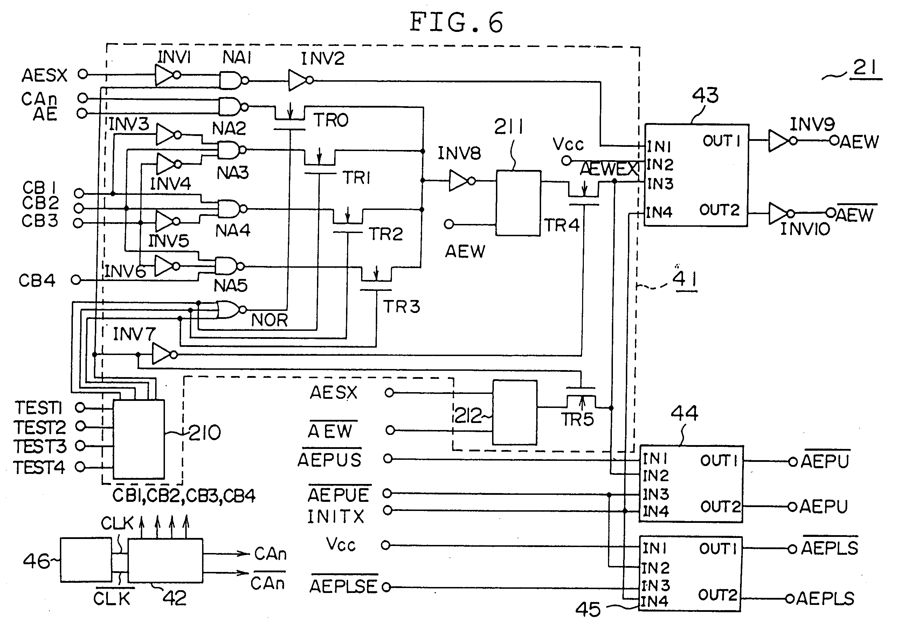

Specifically, the erase/program controller 21 is an illustrative embodiment of the control means 11, a circuit for controlling an erase and a program of data DIN. If i=4 and $N_i$=0, 2, 3 and 10, for example, in an auto-erase and rewrite test, the erase/program controller 21 selects one out of the predetermined write counts 0, 2, 3 and 10 on the basis of the state of the applied voltages of the test mode terminals $TEST_1$ through $TEST_4$ to effectuate a program and erase control. The internal structure of the erase/program controller 21 will be detailed in connection with FIG. 6.

On the basis of control signals S1 supplied from the erase/program controller 21, the program/erase voltage generator 22 supplies an erase/program voltage VPP to the address latch 27, the storage section 28 and a program/read amplifier 29. The control signals S1 includes a pre-programming termination signal (hereinafter, referred to simply as a "signal AEWEX"), the inverted version of an auto-erase initiation signal, $\overline{AESX}$, and so forth which are supplied from latches 43 through 45 described below.

The input/output buffer 23 is a circuit for the input/output of data, e.g., 8-bit data DIN on the basis of control signals S3 supplied from the controller 21 and control signals S2 supplied from the signal generating logic circuit 26.

The command register 24 is a circuit for decoding an 8-bit command and supplying the resultant signal S0 to the status register 30. The data comparison register 25 is a circuit operative on the basis of the control signals S3 for comparing data DIN to program with read programmed data in an auto-erase and rewrite test or presetting a path in case of an erase command and an erase test, and supplying the resultant data to an erase/program controller 21.

The signal generating logic circuit 26 is a circuit for generating control signals S2 and S4 on the basis of resultant signals S0 output from the status register 30. The address latch 27 for latching 19-bit address A0 through A18 in response to, for example, control signals S4 supplied from the signal generating logic circuit 26 and control signals S5 supplied from the controller 21.

It should be noted that the terminals receiving address A0 through A3 also serves as test mode terminals $TEST_1$ through $TEST_4$ the voltage state of which is detected by the voltage detector 210 of the erase/program controller 21. And, the address latch 27 transfers 5-bit address A0 through A4 to a Y-gate subsection 281 in the storage section 28, 10-bit address A5 through A14 to a memory cell array 282 in the storage section 28, and 4-bit address A15 through A18 to a power supply controller 283 in the storage section 28.

The storage section 28 comprises a Y-gate (column gate) section 281, the memory cell array 282 and a source power supply controller 282. The Y-gates 281 select bit lines of a memory cell array on the basis of address A0 through A4 for supplying a program/erase voltage VPP. The memory cell array 282 consists of memory cells which data DIN are written to and read from on the basis of address A0 through A4 and which are formed of, for example, MOS transistors with a floating gate. The source power supply controller 283 is a circuit for controlling the supply of the program/erase voltage VPP on the basis of address A15 through A18.

The program/read amplifier 29 is a circuit for programming and reading data DIN on the basis of the control signals S3 and S4 and the program/erase voltage VPP. The status register 30 is a circuit for controlling the input/output of the erase/program controller 21 and the signal generating logic circuit 26 on the basis of four externally supplied signals of write enable WE, chip enable CE, output enable OE and power down PWD, and the resultant signal S0 supplied from the command register 24.

Referring to FIG. 6 through 9, we discuss the internal structure of an exemplary erase/program controller 21 in the following. For example, an erase/program controller 21 capable of setting up four kinds of write counts including zero in response to the selection of the test mode terminals $TEST_1$ through $TEST_4$ and operative for controlling erase and write according to an erase instruction comprises a write count setter 41, a counter 42, latches 43 through 45 and an oscillator 46 as shown in FIG. 6.

Specifically, the write count setter 41 is an illustrative embodiment of the automated count setter 11A and comprises a voltage detector 210, inverter INV1 through INV8, 2-input NAND gates NA1 and NA2, 3-input NAND gates NA3 through NA5, a 3-input NOR gates NOR, switching transistors TR0 through TR5 and trigger circuits 211 and 212.

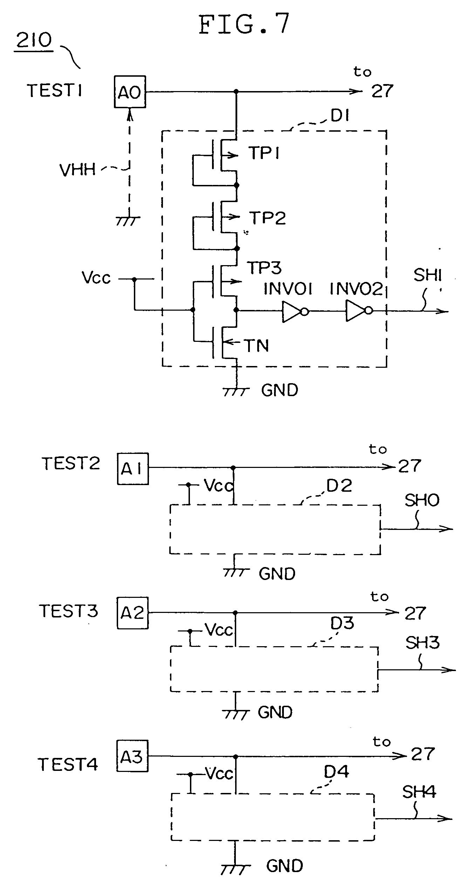

FIG. 7 is an exemplary voltage detector 210 for monitoring the state of the voltages applied to the test mode terminals $TEST_1$ through $TEST_4$. In the

detector 210 there is utilized a power supply voltage detector of Japan Patent Publication No.60,789 issued in 1989 to the applicant of the present invention. The voltage detector 210 comprises four sub-detectors D1 through D4, for example.

Specifically, the sub-detector D1 comprises three p-type field effect transistors TP1 through TP3, an n-type field effect transistors TN, and inverter INV01 and INV02. The source of the transistor TP1 is connected to the terminal $TEST_1$, which also serves as a normal use terminal for receiving, for example, a column address A0. The gate and the drain of a transistor TP1 is connected to the source of the transistor TP2. The gate and the drain of the transistor TP2 is connected to the source of the transistor TP3. The drain of the transistor TP3 is connected to that of the transistor TN and the inverter INV01. The gates of the transistors TN and TP3 are pulled up together to the power supply VCC. The source of the transistor TN is connected to the ground line GND.

The function of the sub-detector D1 is such that when a high voltage VHH is applied to the terminal $TEST_1$, the sub-detector D1 detects it to output a count selection signal $SH_1$ to the write count setter 41.

As in the sub-detector D1, the sub-detectors D2 through D4 each comprise three p-type field effect transistors TP1 through TP3, an n-type field effect transistors TN, and inverter INV01 and INV02, for detecting a high voltage VHH applied to one of the terminals TP2 through TP4 to output the count selection signals $SH_2$ through $SH_4$, respectively. The terminals $TEST_2$ through $TEST_4$ also serves as usually used terminals for receiving column address bits A1 through A3, respectively.

The timing signal generator 200 of FIG. 4 comprises inverter INV1 through INV8, 2-input NAND gates NA1 and NA2, 3-input NAND gates NA3 through NA5, a 3-input NOR gate NOR, switching transistors TR0 through TR5, and trigger circuits 211 and 212. Specifically, the inverter INV1 and INV2 and the 2-input NAND gate NA1 give to a latch 43 a signal $\overline{AESX}$ on the basis of an auto-erase initiation signal AESX based on the result of erase command decoding and the count selection signal SH4. Note that the NAND gate NA1 receives a AESX signal and the count selection signal SH4.

The 2-input NAND gate NA2 yields a negated logical product signal of a signal Can (CA18) indicating the last count value of the counter 42 and an auto-erase signal AE to the transistor TR0. The logical signal is intended for writing data once before an auto-erase.

The gates INV3, INV4 and NA3 yields a negated logical product signal of counter signals $\overline{CB1}$, CB2 and $\overline{CB3}$ derived from the counter 42 to the transistor TR1. Similarly, the gates INV5 and NA4 gives a negated logical product signal of counter signals CB1, CB2 and $\overline{CB3}$ to the transistor TR2. The gates INV6 and NA5 gives a negated logical product signal of counter signals Cb2, $\overline{CB3}$ and CB4 to the transistor TR3. Note that the counter signals CB1 through CB4 are count-setting-purpose ones for setting the write counts for 2, 3 and 10. And, the negated logical product signals are used for output control of the trigger circuit 211.

The gate NOR has its 3 inputs receiving the count selection signals SH1 through SH3 from the voltage detector 210 and its logical sum output connected to the gate of the transistor TR0. Also, the count selection signals SH1 through SH3 from the voltage detector 210 are supplied to the respective gates of the transistors TR1 through TR3.

Thus, each of the transistors TR0 through TR3 is controlled in response to the state of the voltage applied to corresponding one of the test mode terminals TEST1 through TEST3. Each gated output is supplied together to the trigger circuit 211 via the inverter INV8. The trigger circuit 211 supplies a pre-programming termination signal AEWEX to the transistor TR4 on the basis of logical combinations of the counter signals CB1 through CB4 which is selected by the transistors TR0 through TR3 and a pre-programming signal AEW.

The inverter INV7 inverts the count selection signal SH4 and supplies the inverted signal to the gate of the transistor TR4. A trigger circuit 212 supplies a signal AEWEX on the basis of signals AESX and $\overline{AEW}$ to the transistor TR5. The transistors TR4 and TR5 are controlled (gated) by the voltage state of the test mode terminal TEST4 and have their gated outputs or the signals AEWEX wired together and supplied to the latches 43 and 44.

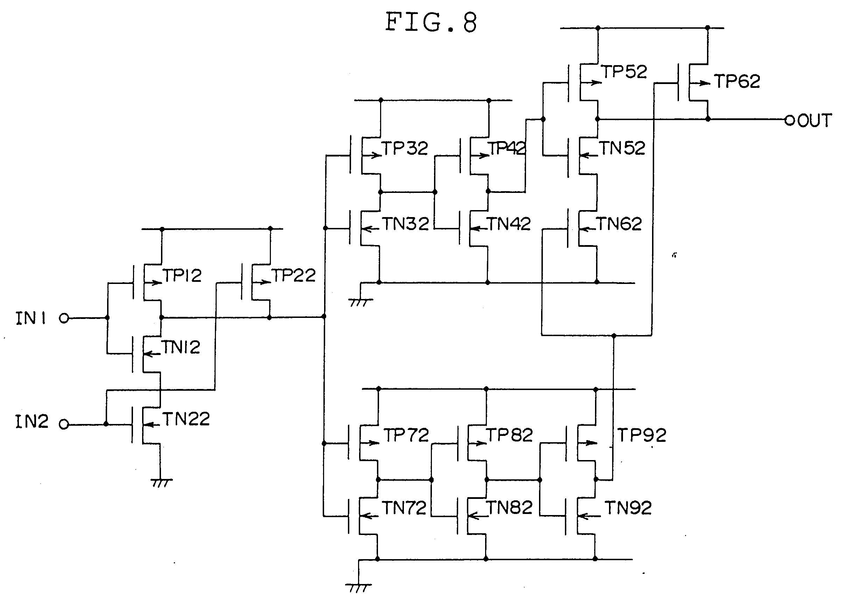

In FIG. 8, each of the trigger circuits 211 and 212 comprises 9 p-type field effect transistors TP12 through TP92 and 9 n-type field effect transistors TN12 through TN92. The input parts IN1 and IN2 of the trigger circuit 211 is supplied with inverter INV8 output signal and a signal AEW, respectively. Similarly, the input parts IN1 and IN2 of the trigger circuit 212 is supplied with signals AESX and $\overline{AEW}$. And, the trigger circuit 211 and 212 issue trigger output signals from their respective output ports OUT.

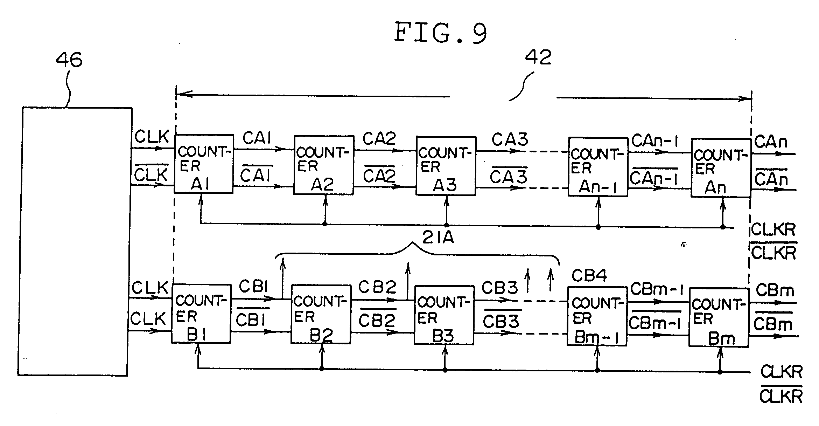

The counter circuit 42 is a counter for generating addresses or counting the number of writes or erases on the basis of a non-inverted clock signal CLK and an inverted clock signal $\overline{CLK}$. For example, as shown in FIG. 9, the counter circuit 42 comprises n counters A1 through An for generating addresses and m counters B1 through Bm for counting the number of writes or erases.

In a preferred embodiment of the invention, the non-inverted output signal CB1 of the counter B1 is supplied via inverter INV3 to the NAND gate NA3 and also supplied to the NAND gate NA4. The non-inverted output signal CB2 of the counter B2 is supplied to the NAND gates NA3 through NA5. The non-inverted output signal CB3 of the counter B3 is supplied via inverter INV 4 through INV6 to the respective NAND gates NA3 through NA5. The non-inverted output signal CB4 of the counter B4 is supplied to the NAND gate NA5.

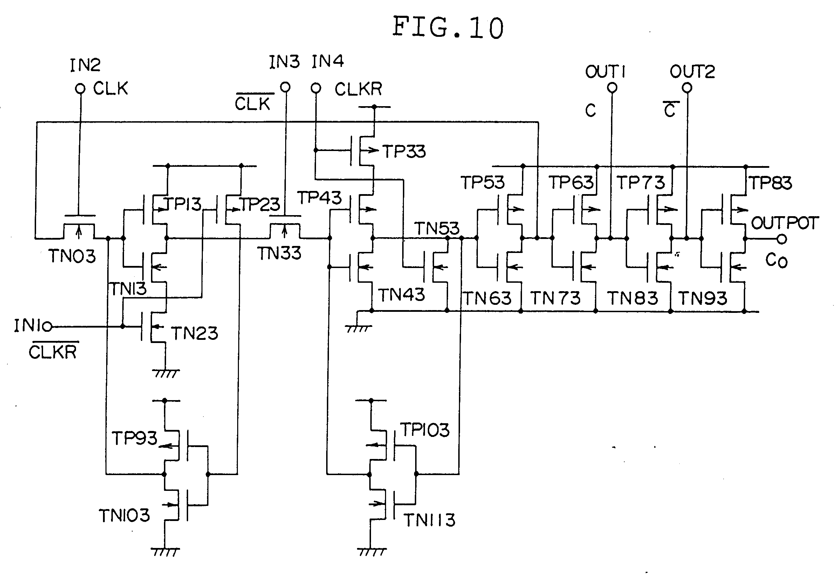

As shown in FIG. 10, each counter comprises 10 p-type field effect transistors TP13 through TP103 and 12 n-type field effect transistors TN03 through TN113. To the input parts IN1 and IN4 of each counter, there are supplied a count clear signal CLKR and an inverted count clear signal $\overline{CLKR}$, respectively. And, each counter receives signals CLK and $\overline{CLK}$ at its input parts IN2 and IN3 and supplies a count output signal C and an inverted count output signal $\overline{C}$ from its output parts OUT1 and OUT2, respectively.

In a preferred embodiment of the invention, as shown in FIG. 6 and listed in Table below, the write counts N1 through N4 associated with the 4 test mode terminals TEST1 through TEST4 are made 2, 3, 10 and 0, respectively.

Table

| TESTi | Ni [times] |
|-------|-----------|
| TEST1 | 2 |
| TEST2 | 3 |
| TEST3 | 10 |
| TEST4 | 0 |

Specifically, the preceding circuit of the transistor TR1 associated with the test mode terminal TEST1 is so arranged as to activate its output to the transistor TR1 when the output CB1 through CB3 of the counter 42 becomes N1=2 in decimal or "010" in binary (by doing this, the terminal TEST1 is allocated for a write count N1), and the transistor TR1 is turned on in response to the voltage state of the test mode terminal TEST1 to select N1, resulting in the output of N1=2. Similarly, in order to output N2=3, the preceding circuit of the transistor TR2 is so arranged on the basis of the counter output condition (CB3, CB2, CB1)= "011" that the terminal TEST2 is allocated for N2, and the transistor TR2 is turned on in response to the voltage state of the test mode terminal TEST2 to select N2. In order to output N3=10, the preceding circuit of the transistor TR3 is so arranged on the basis of the counter output condition (CB4, CB3, CB2)="101" that the terminal TEST3 is allocated for N3=10, and the transistor TR3 is turned on in response to the voltage state of the test mode terminal TEST3 to select N3.

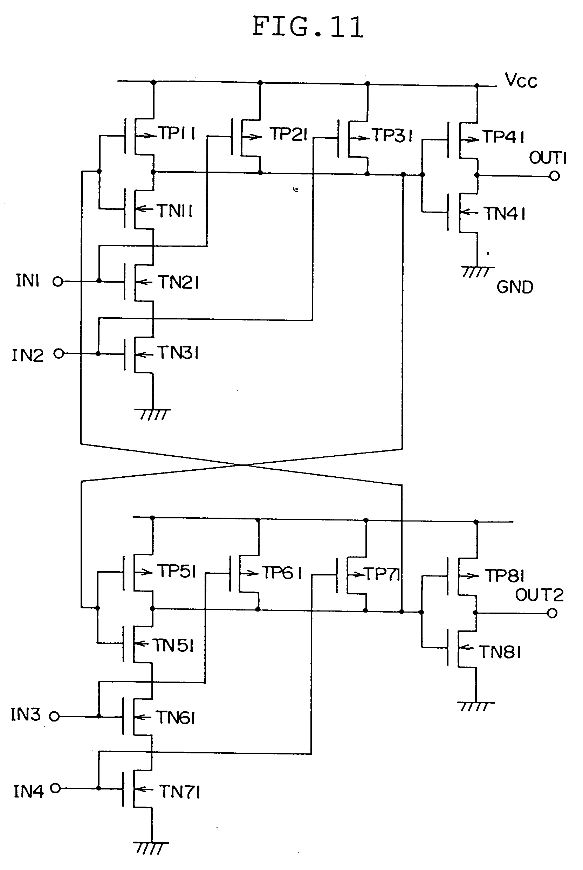

The latch circuit 43 through 45 comprises 8 p-type field effect transistors TP11 through TP81 and 8 n-type field effect transistors TN11 through TN81 as shown in FIG. 11. As for the latch 43, as shown in FIG. 6, its input IN1 is connected to the inverter INV2 of the write count setter 41, its input INV2 is connected to the power supply line VCC, its input INV3 is connected to the transistors TR4 and TR5 of the write count setter 41 and the input INV4 of a latch circuit 44, its input IN4 is connected to the input IN4 of the latch 44 and the input IN4 of the latch 45, its output OUT1 is connected to the inverter INV9, and its output OUT2 is connected to the inverter INV10.

To the input IN1 of the latch 43 is supplied a signal $\overline{AESX}$ based on a auto-erase initiation signal AESX and a count selection signal SH4 and to its input IN2 is supplied the power supply voltage VCC. And, The latch 43 has its input IN3 supplied with a signal AEWEX and its input IN4 supplied with an initial signal INITX. On the basis of these signals, the latch 43 has its output OUT1 supplying a signal AEW via the inverter INV9 and its output OUT2 supplying a signal $\overline{AEW}$ via the inverter INV10.

An input IN1 of the latch 44 is connected to the point from which a signal $\overline{AEPUS}$ is supplied. The input IN2 of the latch 44 is as described above.

The input IN3 of the latch 44 is connected to an $\overline{AEPUE}$-supplying point and input IN2 of latch circuit 45. The $\overline{AEPUE}$ is erase-voltage-control-signal. Its input IN4 is as described above.

The latch 44 has its input IN1 supplied with a signal $\overline{AEPUS}$, its input IN2 supplied with a signal AEWEX, its input IN3 supplied with the erase voltage control signal $\overline{AEPUE}$ and its input IN4 supplied with a signal INITX. On the basis of these signals, the latch 44 has its output OUT1 supplying a non-inverted signal $\overline{AEPU}$ and its output OUT2 supplying an inverted signal AEPU.

As shown in FIG. 6, the latch 45 has its input IN1 connected to the power supply line VCC and its input IN3 connected to an $\overline{AEPLSE}$-supplying point. The $\overline{AEPLSE}$ is auto-erase-pulse-termination-signal. Its input IN2 and IN4 has been described above.

The latch 45 has its input IN1 supplied with the power supply voltage VCC, its input IN2 supplied with the signal $\overline{AEPUE}$, its input IN3 supplied with the auto-erase pulse termination signal $\overline{AEPLSE}$ and its input IN4 supplied with the signal INITX. On the basis of these signals, the latch 45 has its output OUT1 supplying a non-inverted auto-erase pulse signal $\overline{AEPLS}$ and its output OUT2 supplying an inverted signal AEPLS.

An oscillator 46 generates a reference clock signal CLK and its inverted version $\overline{CLK}$ to supply them to the counter circuit 42.

Now, we discuss the operation of the erase/write controller 21 in the following. If, for example, all the test mode terminals are in a unselected state (in case of ordinary operation), then out of recognition that the mode should not enter any test mode, a data write is executed once before erasure and a (pre-programming termination) signal AEWEX for entering the auto-erase operation and an (auto-erase initiation) signal AESX are generated from by the write count setter 41. On the basis of above described signals Can, AE, AESX and INITX and the power supply voltage VCC, the latch 43 has its output OUT1 supplying a signal AEW to be inverted by the inverter INV9 and its output OUT2 supplying a signal $\overline{AEW}$ to be inverted by the inverter INV10.

Similarly, on the basis of signals $\overline{AEPUS}$, AEWEX, $\overline{AEPUE}$ and INITX, the latch 44 has its output OUT1 supplying a signal $\overline{AEPU}$ and its output OUT2 supplying a signal AEPU.

Further, on the basis of the power supply voltage VCC and signals $\overline{AEPUE}$, INITX and $\overline{AEPLSE}$, the latch 45 has its output OUT1 supplying a signal $\overline{AEPLS}$ and its output OUT2 supplying a signal AEPLS.

In an automated erase and write test, if the test mode terminal, e.g., TEST4 is selected among the terminals TEST1 through TEST4, that is, a test-purpose high voltage VHH is applied to TEST4, then the write count setter 41 generates a pre-programming termination signal AEWEX for omitting a write before erasure (N4=0). The signal AEW based on to the signal AEWEX is output through the latch 43 output OUT1 and the inverter INV9. Similarly, the inverted signal $\overline{AEW}$ is output through the latch 43 output OUT2 and the inverter INV10.

Again, the latch 44 has its output OUT1 supplying a signal $\overline{AEPU}$ and its output OUT2 supplying a signal AEPU. And, the latch 45 has its output OUT1 supplying a signal $\overline{AEPLS}$ and its output OUT2 supplying a signal AEPLS.

Thus, a data write before erasure is eliminated. Subsequently, according to an erase instruction, the erase/write controller 21 executes an auto-erase test in which an erase operation is repeated.

Further, if any other test mode terminal TESTi than TEST4 is selected (i=1, 2, 3), then the count selection signal Shi associated with the selected terminal TESTi is activated thereby to select the write count Ni associated with the selected terminal TESTi among the predetermined write counts N1(=2), N2(=3) and N3(=10). In this way, a data write is executed Ni times before erasure, and then the signals AEWEX and AESX is generated by the write count setter 41 for entering an erase operation.

In this case, one of the transistors TR1 through TR3 operates in an "on" state which the activated count selection signal Shi is connected to. Also, when the test mode terminal TEST4 is in a unselected state, the transistor TR4 is "on" while the transistor TR5 is "off". In this case, the trigger circuit 211 generates a signal AEWEX as a trigger output on the basis of the output signal of the inverter INV8 and a signal AEW.

The signal AEW based on to the signal AEWEX is output through the latch 43 output OUT1 and the inverter INV9. Similarly, the inverted signal $\overline{AEW}$ is output through the latch 43 output OUT2 and the inverter INV10.

Again, the latch 44 has its output OUT1 supplying a signal $\overline{AEPU}$ and its output OUT2 supplying a signal AEPU. And, the latch 45 has its output OUT1 supplying a signal $\overline{AEPLS}$ and its output OUT2 supplying a signal AEPLS. Thus, data DIN is written Ni times in response to each case before erasure.

Concretely, on the basis of signals AEW, $\overline{AEW}$, AEPU, $\overline{AEPU}$, AEPLS and $\overline{AEPLS}$, the erase/write voltage generator 22 connected to the erase/write controller 21 write data DIN to the storage section 28 and subsequently executes a operation of erasing data DIN repeatedly.

Thus, in accordance with the flash memory according to a preferred embodiment of the invention, a erase/write controller 21 is provided with a write count setter 41 and a voltage detector 210 of the write count setter 41 is connected to test mode terminals TEST1 through TEST4 which serve double as an ordinary input and test terminal.

Therefore, it is possible to enter the test mode automatically by applying a high voltage to one of the test mode terminals TEST1 through TEST4 and to eliminate a pre-programming by applying the high voltage to the test mode terminal TEST4. It is also possible to change the pre-programming count in response to the selection among the terminals TEST1 through TEST3 and an erase command and to make a rewrite test only by means of an auto-erase.

Note that the selection of the terminal TEST4 causes the signal AESX to be neglected, so the signal AEW is not issued, nor is a pre-programming executed. Accordingly, only an auto-erase operation is executed, that is, following the first one-time programming, an erase operation is executed 1500 times or so. Since a write instruction directing a fixed number of data write according to the related art is disabled before an erase operation, an auto-erase is immediately started without wasting time for instruction decoding. So, a cycling test wherein a write and an erase operation (or an electrical rewrite) are repeated can be executed for a short time.

It should be noted that though we discussed the case of 4 write counts of 0, 2, 3 and 10 in a preferred embodiment of the invention, a desired number of write counts can be set by arranging the suitable combinations of the outputs of a counter for the write count.

**Claims**

1. An electrically chip-erasable nonvolatile semiconductor memory comprising memory cells, which can be written to before a data erase of said memory cells so as to level the threshold voltage of a gate of a transistor constituting each cell; characterised by:

    output means (11A) for outputting a count selection signal (SH$_i$) and one of a plurality of preset data write counts (N$_i$), which define the number of write operations before data erase of said memory cells, whereby said preset data write counts (N$_i$) differ from one another and include one write count being zero; and

control means (11) for writing data to said memory cells according to said data write count (N$_i$) from said output means and executing data write and erase in response to an erase signal (AESX).

2. The nonvolatile semiconductor memory of claim 1 wherein said output means comprises:

    a voltage detector (210) for detecting said count selection signal (SH$_i$); and
    a timing signal generator (200) for generating a pre-erase write termination signal and the inverted version ($\overline{AESX}$) of said erase signal (AESX) on the basis of:

        said count selection signal (SH$_i$) supplied from said voltage detector (210), said erase signal (AESX), a pre-erase write control signal (AE) and a count setting signal (CB1...CBm), said last three signals being supplied from some other circuit than said voltage detector.

3. The nonvolatile semiconductor memory of claim 2 wherein

    said count selection signals (SH$_i$) are supplied through at least one of terminals connected to an inner circuit which is controlled by said control means (11).

4. The nonvolatile semiconductor memory of claim 3 wherein

    said terminals are address terminals of said memory cells.

5. The nonvolatile semiconductor memory of claim 2 wherein

    said count selection signal (SH$_i$) is higher than a normally used voltage (V$_{HH}$).

6. A test method of an electrically chip-erasable nonvolatile semiconductor memory comprising memory cells, which can be written to before a data erase of said memory cell so as to level the threshold voltage of a gate of a transistor constituting each cell, said method comprising the steps of:

    presetting a plurality of data write counts (N$_i$) which define the number of write operations before data erase of said memory cells, whereby said preset data write counts (N$_i$) differ from one another and include one write count being zero;

selecting one of said preset write counts ($N_i$) in an automated erase and rewrite test; and

executing data writes according to said selected data write count and executing data write and erase in response to an erase signal (AESX).

7. The test method of the nonvolatile semiconductor memory of claim 6 wherein

said data write and erase according to the erase signal (AESX) are repeated a desired number of times.

**Patentansprüche**

1. Elektrisch baustein-löschbarer, nicht flüchtiger Halbleiterspeicher mit Speicherzellen, die vor einem Datenlöschen beschreibbar sind, um die Schwellenspannungen der Gate-Elektroden der Transistoren, die die Zellen jeweils darstellen, einander anzugleichen, **gekennzeichnet durch**

eine Ausgangseinrichtung (11A) zur Ausgabe eines Zählwert-Auswahlsignals ($SH_i$) und eines aus einer Vielzahl voreingestellter Datenschreibzählwerte ($N_i$),die die Anzahl der Schreiboperationen vor dem Datenlöschen der Speicherzellen definieren, wobei die voreingestellten Datenschreibzählwerte ($N_i$) sich voneinander unterscheiden und einen Datenschreibzählwert mit dem Wert null enthalten, und

eine Steuereinrichtung (11), um Daten entsprechend dem Datenschreibzählwert ($N_i$) mit der Ausgangseinrichtung in die Speicherzellen einzuschreiben und ansprechend auf ein Löschsignal (AESX) ein Datenschreiben und -löschen auszuführen.

2. Nicht flüchtiger Halbleiterspeicher nach Anspruch 1, bei dem die Ausgangseinrichtung

einen Spannungsdetektor (210) zum Erfassen des Zählwert-Auswahlsignals ($SH_i$) und einen Zeitsignalgenerator (200) aufweist, um ein dem Löschen vorhergehendes Schreibende-Signal und das Invertierte ($\overline{AESX}$) des Löschsignals (AESX) zu erzeugen auf der Basis des Zählwert-Auswahlsignals ($SH_i$) aus dem Spannungsdetektor (210), des Löschsignals (AESX), eines dem Löschen vorhergehenden Schreibsteuersignals (AE) und eines Zählwertsetzsignals (CB1 ... CBm), wobei die letzteren drei Signale von anderen Schaltungsteilen als dem Spannungsdetektor geliefert werden.

3. Nicht flüchtiger Halbleiterspeicher nach Anspruch 2, bei dem die Zählwert-Auswahlsignale ($SH_i$) über mindestens einen der Anschlüsse zugeführt werden, die mit einer internen Schaltung verbunden sind, die von der Steuereinrichtung (11) gesteuert wird.

4. Nicht flüchtiger Halbleiterspeicher nach Anspruch 3, bei dem die Anschlüsse die Adressanschlüsse der Speicherzellen sind.

5. Nicht flüchtiger Halbleiterspeicher nach Anspruch 2, bei dem das Zählwert-Auswahlsignal ($SH_i$) höher ist als eine normalerweise verwendete Spannung ($V_{HH}$).

6. Prüfverfahren für einen elektrisch baustein-löschbaren, nicht flüchtigen Halbleiterspeicher mit Speicherzellen, in die vor einem Datenlöschen der Speicherzellen geschrieben werden kann, um die Schwellenspannungen der Gate-Elektroden der Transistoren, die die Zellen jeweils darstellen, einander anzugleichen, welches Verfahren folgende Schritte aufweist:

Voreinstellen einer Vielzahl von Datenschreibzählwerten ($N_i$), die die Anzahl der Schreiboperationen vor einem Datenlöschen der Speicherzellen vorgeben, wobei die voreingestellten Datenschreibzählwerte ($N_i$) sich unterscheiden und einen Datenschreibzählwert mit dem Wert null enthalten, Auswählen eines der voreingestellten Schreibzählwerte ($N_i$) in einem automatisierten Lösch- und Rückschreibtest und Ausführen von Datenschreiboperationen entsprechend dem gewählten Datenschreibzählwert sowie Ausführen des Datenschreibens und -löschens ansprechend auf ein Löschsignal (AESX).

7. Prüfverfahren für nicht flüchtige Halbleiterspeicher nach Anspruch 6, bei dem das Datenschreiben und -löschen ansprechend auf das Löschsignal (AESX) eine gewünschte Anzahl von Malen wiederholt wird.

**Revendications**

1. Mémoire à semiconducteur non volatile électriquement effaçable sur puce comprenant des cellules de mémoire qui peuvent être écrites avant un effacement de données desdites cellules de mémoire de manière à niveler la tension de seuil d'une grille d'un transistor constituant chaque cellule, caractérisée par :

un moyen de sortie (11A) pour émettre en sortie un signal de sélection de comptage (SH$_i$) et l'un d'une pluralité de comptages d'écritures de données préétablis (N$_i$), qui définissent le nombre d'opérations d'écriture avant un effacement de données desdites cellules de mémoire, de telle sorte que lesdits comptages d'écritures de données préétablis (N$_i$) diffèrent les uns des autres et incluent un comptage d'écritures qui est égal à zéro ; et

un moyen de commande (11) pour écrire des données dans lesdites cellules de mémoire conformément audit comptage d'écritures de données (N$_i$) en provenance dudit moyen de sortie et pour exécuter une écriture et un effacement de données en réponse à un signal d'effacement (AESX).

2. Mémoire à semiconducteur non volatile selon la revendication 1, dans laquelle ledit moyen de sortie comprend :

un détecteur de tension (210) pour détecter ledit signal de sélection de comptage (SH$_i$) ; et un générateur de signal de cadencement (200) pour générer un signal de terminaison d'écriture de pré-effacement et la version inversée (/AESX) dudit signal d'effacement (AESX) sur la base dudit signal de sélection de comptage (SH$_i$) appliqué depuis ledit détecteur de tension (210), dudit signal d'effacement (AESX), d'un signal de commande d'écriture de pré-effacement (AE) et d'un signal d'établissement de comptage (CB1... CBm), lesdits trois derniers signaux étant appliqués depuis un quelconque autre circuit que ledit détecteur de tension.

3. Mémoire à semiconducteur non volatile selon la revendication 2, dans laquelle lesdits signaux de sélection de comptage (SH$_i$) sont appliqués par l'intermédiaire d'au moins l'une des bornes connectées à un circuit interne comme commandé par ledit moyen de commande (11).

4. Mémoire à semiconducteur non volatile selon la revendication 3, dans laquelle lesdites bornes sont des bornes d'adresse desdites cellules de mémoire.

5. Mémoire à semiconducteur non volatile selon la revendication 2, dans laquelle ledit signal de sélection de comptage (SH$_i$) est supérieur à une tension utilisée normalement (V$_{HH}$).

6. Procédé de test d'une mémoire à semiconducteur non volatile électriquement effaçable sur puce comprenant des cellules de mémoire qui peuvent être écrites avant un effacement de données desdites cellules de mémoire de manière à niveler la tension de seuil d'une grille d'un transistor constituant chaque cellule, ledit procédé comprenant les étapes de :

préétablissement d'une pluralité de comptages d'écritures de données (N$_i$) qui définissent le nombre d'opérations d'écriture avant un effacement de données desdites cellules de mémoire de telle sorte que lesdits comptages d'écritures de données préétablis (N$_i$) diffèrent les uns des autres et incluent un comptage d'écriture qui est égal à zéro ; sélection de l'un desdits comptages d'écritures préétablis (N$_i$) lors d'un test d'effacement et de réécriture automatisés ; et exécution d'écritures de données conformément audit comptage d'écritures de données sélectionné et exécution d'une écriture et d'un effacement de données en réponse à un signal d'effacement (AESX).

7. Procédé de test de la mémoire à semiconducteur non volatile selon la revendication 6, dans lequel :

lesdits écriture et effacement de données conformément au signal d'effacement (AESX) sont répétés un nombre souhaité de fois.

# FIG.1A
# (RELATED ART)

# FIG.1B

# FIG.2
## (RELATED ART)

# FIG.3

DIN

DOUT

~ 11

~ 11A

TEST1    TEST2    ~    TEST n

# FIG.4

11A

AESX

AE

$\overline{AESX}$

AEWEX

~ 200

SHI ~ SHn

TEST 1
TEST 2
~
TEST n

VHH ~

210

CBI ~ CBm

# FIG.5

FIG.6

# FIG.7

# FIG.8

EP 0 642 135 B1

EP 0 642 135 B1

# FIG.9

46

42

21A

| CLK | COUNTER A1 | CA1 | COUNTER A2 | CA2 | COUNTER A3 | CA3 | COUNTER An-1 | CAn-1 | COUNTER An | CAn |

$\overline{CLK}$  $\overline{CA1}$  $\overline{CA2}$  $\overline{CA3}$  $\overline{CAn-1}$  $\overline{CAn}$

CLKR
$\overline{CLKR}$

CLK COUNTER B1 CB1 COUNTER B2 CB2 COUNTER B3 CB3 CB4 COUNTER Bm-1 CBm-1 COUNTER Bm CBm

$\overline{CLK}$  $\overline{CB1}$  $\overline{CB2}$  $\overline{CB3}$  $\overline{CBm-1}$  $\overline{CBm}$

CLKR
$\overline{CLKR}$

19

FIG. 10

# FIG.11